Europäisches Patentamt

European Patent Office

Office européen des brevets

(19)

(11)  EP 0 561 045 B1

(12)  **EUROPÄISCHE PATENTSCHRIFT**

(45) Veröffentlichungstag und Bekanntmachung des
Hinweises auf die Patenterteilung:
**30.09.1998  Patentblatt 1998/40**

(51) Int Cl.[6]: **H03F 3/60**, H03F 3/45,
H03F 3/191

(21) Anmeldenummer: **92119304.1**

(22) Anmeldetag: **11.11.1992**

(54) **Breitband-Verstärkerstufe mit einem Ausgangsanschluss**

Broad-band amplifier stage with one output terminal

Etage amplificateur à large bande à un terminal de sortie

(84) Benannte Vertragsstaaten:
**DE DK FR GB IT**

(30) Priorität: **19.11.1991  DE 4138052**

(43) Veröffentlichungstag der Anmeldung:
**22.09.1993  Patentblatt 1993/38**

(73) Patentinhaber: **SIEMENS
AKTIENGESELLSCHAFT
80333 München (DE)**

(72) Erfinder: **Meyer, Fritz, Dr.-Ing.
W-8034 Germering (DE)**

(56) Entgegenhaltungen:
**US-A- 4 797 628**

- **IBM TECHNICAL DISCLOSURE BULLETIN. Bd.
9, Nr. 6, November 1966, NEW YORK US Seite 710
T.I. KIRKPATRICK 'TRANSFORMER-LOADED
DIFFERENTIAL AMPLIFIER'**
- **PATENT ABSTRACTS OF JAPAN vol. 11, no. 019
(P-537)20. Januar 1987**

**Beschreibung**

Die Erfindung betrifft eine Breitband-Verstärkerstufe entsprechend dem Oberbegriff des Anspruchs 1.

Zur Versteilerung und Verstärkung impulsförmiger Signale eignen sich bekanntlich wegen ihrer relativ großen Bandbreite emittergekoppelte Differenzverstärker recht gut. Sie gestatten auch auf einfache Weise einen Abgleich von Amplitude und Tastverhältnis der Impulse beispielsweise zur Einstellung vorgegebener Impulsformen für die sogenannten Augendiagramme. Werden jedoch beispielsweise zur Auffächerung von Ausgangssignalen mehrere solcher Differenzverstärker in einer Baugruppe benötigt, dann steigt mit der Signalleistung auch die Leistungsaufnahme soweit an, daß innerhalb einer Baugruppe der Aufwand für Kühlmaßnahmen stören kann. Das Problem bei derartigen emittergekoppelten Differenzverstärkern besteht also darin, daß das Verhältnis von erzeugter Signalleistung zur Gesamtleistungsaufnahme in vielen Fällen ungünstig ist.

Aus "Halbleiter-Schaltungstechnik" von Tietze und Schenk, Springerverlag Berlin, 1989, ist auf Seiten 500 + 501 ein Gegentakt-Emitterfolger bekannt, bei dem die Ausgangsignale zweier Transistoren sich an einem Ausgangsanschluß addieren. Nachteilig bei dieser bekannten Lösung ist aber, daß es sich nicht um einen Spannungsverstärker sondern nur um einen Spannungsfolger handelt, daß entweder zwei Betriebsspannungen oder eine doppelt so hohe Betriebsspannung wie bei üblichen Differenzverstärkern erforderlich ist, daß sowohl pnp- als npn-Transistoren benötigt werden, wobei die pnp-Transistoren bekanntlich wesentlich langsamer umschalten als die npn-Transistoren und außerdem die verwendete Emitterfolgerschaltung bei breitbandiger Anwendung zu parasitären Hochfrequenzschwingungen neigt und damit schwierig zu stabilisieren ist.

Es ist auch bekannt, die Leistungsaufnahme von Verstärkern durch die Verwendung von Feldeffekttransistoren zu reduzieren. Im vorliegenden Falle soll jedoch ein Verstärker mit einer Bandbreite von ca. 100 kHZ bis zu etwa 2 GHz mit einem Ausgangsstrom von etwa 25 mA realisiert werden. Die dafür verwendeten Transistoren müssen Transitfrequenzen von etwa 5 GHz aufweisen und entsprechende Ausgangsströme liefern können, so daß nur bipolare Transistoren verwendet werden können.

Aus dem IBM Technical Disclosure Bulletin, Vol. 9, Nr. 6, Nov. 1966, Seite 710; T.I.Kirkpatrick, "Transformer-loaded differential amplifier" ist bereits ein Differenzverstärker bekannt, bei dem die Kollektoranschlüsse der beiden Differenzverstärker jeweils mit einem Ausgangsanschluß, über einen Widerstand mit einer Betriebsspannungsquelle und mit jeweils einer Wicklung eines Transformators verbunden sind, um eine wirkungsvolle Gleichtaktunterdrückung zu erreichen.

Die Aufgabe bei der Erfindung besteht also darin, eine Breitband-Verstärkerstufe der eingangs erwähnten Art anzugeben, die ein günstiges Verhältnis von erzeugter Signalleistung im gewünschten Leistungs- und Frequenz bereich zur Gesamtleistungsaufnahme aufweist.

Erfindungsgemäß wird die Aufgabe durch eine Breitband-Verstärkerstufe der eingangs erwähnten Art gelöst, die durch die Merkmale des Patentanspruchs 1 weitergebildet ist. Von besonderem Vorteil bei der erfindungsgemäßen Breitband-Verstärkerstufe ist die Möglichkeit, npn-Transistoren verwenden zu können, so daß die benötigten Transistoren auch Teil einer integrierten Schaltung sein können und damit beispielsweise der Endverstärker in die Gesamtschaltung mitintegriert werden kann. Die erfindungsgemäße Breitband-Verstärkerstufe kann in vorteilhafter Weise entsprechend dem Patentanspruch 2 auch im Gegentakt angesteuert werden, so daß sich die Umschaltgeschwindigkeit weiter erhöht. In den Patentansprüchen 3-5 sind Breitband-Verstärkerstufen mit besonders einfach zu realisierenden Leitungsanordnungen beschrieben.

Die Erfindung soll im folgenden anhand eines in der Zeichnung dargestellten Ausführungsbeispiels näher erläutert werden.

Dabei zeigt

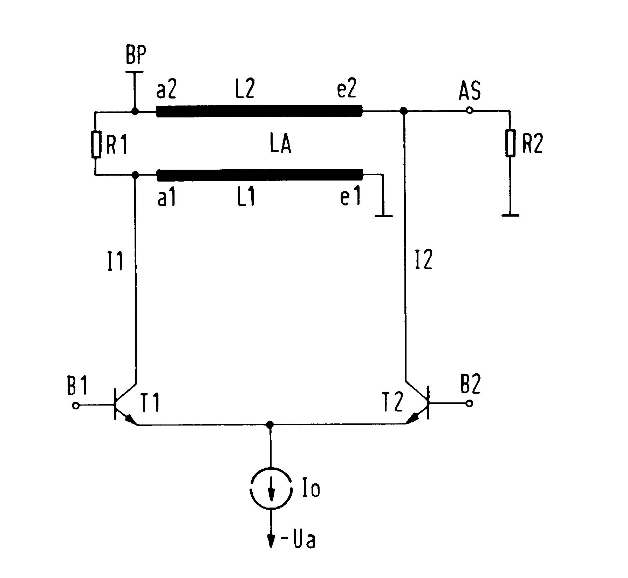

Fig. 1    die Prinzipdarstellung einer erfindungsgemäßen Breitband-Verstärkerstufe mit einem Abschlußwiderstand als Verbraucher.

In der Figur 1 sind ein erster und ein zweiter npn-Transistor T1, T2 zu einem emittergekoppelten Differenzverstärker zusammengeschaltet, in dem deren Emitteranschlüsse in bekannter Weise miteinander und über eine Stromquelle Io mit einer Betriebsspannungsquelle - Ua verbunden sind. Die Spannungsteileranordnungen zur Erzeugung der Basisströme sind wegen ihrer allgemeinen Bekanntheit weggelassen. Es können bedarfsweise an den Basisanschluß B1 des ersten Transistors T1 ein Signaleingang und an den Basisanschluß B2 des zweiten Transistors T2 eine Referenzspannungsquelle angeschlossen werden, zur Erhöhung der Umschaltgeschwindigkeit ist es aber zweckmäßig, beide Basisanschlüsse mit einer Signalquelle für eine Gegentaktansteuerung zu verbinden. Der Kollektoranschluß des ersten Transistors T1 ist mit einem ersten Anschluß a1 eines ersten Leiters L1 einer Leitungsanordnung LA verbunden. Die Leitungsanordnung LA enthält außerdem einen zweiten Leiter L2, der parallel zum ersten Leiter angeordnet ist. Die beiden ersten Anschlüsse a1, a2 des ersten und des zweiten Leiters L1, L2 sind einander unmittelbar benachbart, ebenfalls die beiden zweiten Anschlüsse e1, e2 dieser Leiter. Der erste Anschluß a1 des ersten Leiters L1 ist über einen ersten Widerstand R1 mit dem ersten Anschluß a2 des zweiten Leiters L2 sowie mit Bezugspotential BP verbunden. Der zweite Anschluß e1 des ersten Leiters L1 ist mit Bezugspotential verbunden, während der zweite Anschluß e2 des zweiten Leiters L2 mit dem Kollektoranschluß des zweiten Transistors T2 sowie über den Ausgangsanschluß AS mit dem den Verbraucher darstellenden zweiten Widerstand R2 verbunden. Die beiden Leiter L1, L2 können die beiden Leiter einer Koaxialleitung oder einer symmetrischen Paralleldrahtleitung sein, die auf einen hochpermeablen Ferritkern gewickelt sind.

Die Kollektorströme beider Transistoren T1, T2 speisen auf unterschiedliche Weise die Leitungsanordnung LA mit dem Wellenwiderstand Z. Nimmt man an, daß die Leitungsanordnung beidseitig reflexionsfrei abgeschlossen ist, also

$$R1 = R2 = Z$$

ist,
dann ist auch der Innenwiderstand

$$Ri = Z.$$

Der auf einen Spannungssprung an den Eingängen folgenden Kollektorstromänderung von z.B. + di eines der Transistoren entspricht dann eine Kollektorstromänderung von - di des anderen Transistors. Da die Lastwiderstände an den Kollektoren jeweils Z/2 betragen, werden am ersten Anschluß al des ersten Leiters L1 und am zweiten Anschluß e2 des zweiten Leiters L2 gleiche Spannungswellen als Produkte der Kollektorstromänderung mit dem halben Wellenwiderstand erzeugt, die von beiden Seiten in die Leitungsanordnung eingespeist werden. Die zwischen beiden Leitern L1, L2 laufenden Spannungswellen haben die gleiche Polarität. Sie treffen sich in der Leitungsmitte und verschwinden reflexionsfrei in den Abschlußwiderständen R1, R2, wobei am Lastwiderstand R2 zunächst die vom zweiten Transistor T2 ausgehende Spannungswelle eintrifft. Nach der Laufzeit durch die Leitungsanordnung überlagert sich dieser die vom ersten Transistor T1 ausgehende Welle zum doppelten Spannungswert. Dieser theoretisch treppenförmige Verlauf der Ausgangsspannung wird durch die Tiefpaßfunktion der Transistoren geglättet, so daß sich ein stetiger Verlauf für die Ausgangsspannung ergibt, sofern die Laufzeit der Leitung unter einem bestimmten Maximalwert liegt. Beim Ausführungsbeispiel wurde die Leitungsanordnung dadurch realisiert, daß vier Windungen einer ParalleldrahtLeitung mit einem Wellenwiderstand von 75 Ohm auf einen Ferritkern (Siemens B 62152-A7-X30) aufgewickelt wurden, dadurch konnte bei Verwendung von Transistoren mit Transitfrequenzen von etwa 5 GHz eine obere Grenzfrequenz von etwa 2 GHz und eine untere Grenzfrequenz von etwa 50 kHz für die erfindungsgemäße Breitband-Verstärkerstufe erreicht werden.

**Patentansprüche**

1. Breitband-Verstärkerstufe für Signale bis in den Gigahertzbereich mit einem, zwei Transistoren enthaltenden emittergekoppelten Differenzverstärker und einem Ausgangsanschluß, **dadurch gekennzeichnet,**
   daß die Kollektoranschlüsse eines ersten und eines zweiten Transistors (T1, T2) mit einer, einen parallel zueinander angeordneten ersten und zweiten Leiter (L1, L2) enthaltenden Leitungsanordnung (LA) so verbunden sind, daß der Kollektoranschluß des ersten Transistors (T1) mit einem ersten Anschluß (a1) des ersten Leiters (L1) und über einen ersten Widerstand (R1) mit Bezugspotential (BP) und mit einem, dem ersten Anschluß (a1) des ersten Leiters (L1) unmittelbar benachbarten ersten Anschluß (a2) des zweiten Leiters (L2) verbunden ist, daß der Kollektoranschluß des zweiten Transistors (T2) mit einem zweiten Anschluß (e2) des zweiten Leiters sowie mit dem Ausgangsanschluß (AS) verbunden ist, daß der zweite Anschluß (e1) des ersten Leiters (L1) aem zweiten Anschluß (12) des zweiten Leiters unmittelbar benachbart und an Bezugspotential (BP) angeschlossen ist und daß die Leitungsanordnung (LA) durch den ersten Widerstand (R1) einerseits und einen an den Ausgangsanschluß angeschlossenen Verbraucherwiderstand (R2) andererseits wenigstens annähernd reflexionsfrei abgeschlossen ist.

2. Breitband-Verstärkerstufe nach Patentanspruch 1, **dadurch gekennzeichnet,**
   daß die Basisanschlüsse (B1, B2) des ersten und des zweiten Transistors (T1, T2) mit einer Signalquelle für eine Gegentaktansteuerung verbunden sind.

3. Breitband-Verstärkerstufe nach Patentanspruch 1, **dadurch gekennzeichnet,**
   daß der erste und der zweite Leiter (L1, L2) zu einer Paralleldrahtleitung zusammengefaßt sind.

4. Breitband-Verstärkerstufe nach Patentanspruch 1, **dadurch gekennzeichnet,**
   daß der erste und der zweite Leiter (L1, L2) zu einer Koaxialleitung zusammengefaßt sind.

5. Breitband-Verstärkerstufe nach Patentansprüchen 1, 3 oder 4, **dadurch gekennzeichnet,**
   daß die Leiter auf einen hochpermeablen Ferritkern aufgewickelt sind.

**Claims**

1. Broadband amplifier stage for signals ranging up to the gigahertz band, having an emitter-coupled differential amplifier containing two transistors and having an output terminal, characterized in that the collector terminals of a first and of a second transistor (T1,T2) are connected to a line arrangement (LA), which contains a first and second conductor (L1,L2) arranged parallel to one another, in such a way that the collector terminal of the first transistor (T1) is connected to a first terminal (a1) of the first conductor (L1) and, via a first resistor (R1) to reference-earth potential (BP) and to a first terminal (a2) of the second conductor (L2), which terminal (a2) is directly adjacent to the first terminal (a1) of the first conductor (L1), in that the collector terminal of the second transistor (T2) is connected to a second terminal (e2) of the second conductor and also to the output terminal (AS), in that the second terminal (e1) of the first conductor (L1) is directly adjacent to the second terminal (e2) of the second conductor and is connected to reference-earth potential (BP), and in that the line arrangement (LA) is terminated, in a manner at least approximately free from reflections, by the first resistor (R1), on the one hand and a load resistor (R2) connected to the output terminal, on the other hand.

2. Broadband amplifier stage according to Patent Claim 1, characterized in that the base terminals (B1,B2) of the first and second transistors (T1,T2) are connected to a signal source for push-pull driving.

3. Broadband amplifier stage according to Patent Claim 1, characterized in that the first and second conductors (L1,L2) are combined to form a parallel-wire line.

4. Broadband amplifier stage according to Patent Claim 1, characterized in that the first and second conductors (L1,L2) are combined to form a coaxial line.

5. Broadband amplifier stage according to Patent Claims 1, 3 or 4, characterized in that the conductors are wound onto a ferrite core of high permeability.

**Revendications**

1. Etage amplificateur à large bande pour des signaux jusqu'au domaine des gigahertz, comportant des amplificateurs différentiels, couplés par émetteur, contenant deux transistors et une borne de sortie. caractérisé en ce que les bornes de collecteur d'un premier et d'un deuxième transistors (T1,T2) sont reliées à un dispositif (LA) de lignes comportant un premier et un deuxième conducteurs (L1,L2) qui sont montés en parallèles l'un à l'autre, de telle manière que la borne de collecteur du premier transistor (T1) est reliée à une première borne (a1) du premier conducteur (L1) et, par l'intermédiaire d'une première résistance (R1), au potentiel (BP) de référence et à une première borne (a2) du deuxième conducteur (L2) directement voisine de la première borne (a1) du premier conducteur (L1), en ce que la borne de collecteur du deuxième transistor (T2) est reliée à une deuxième borne (e2) du deuxième conducteur, ainsi qu'à la borne (AS) de sortie, en ce que la deuxième borne (e1) du premier conducteur (L1) est directement voisine de la deuxième borne (e2) du deuxième conducteur et est raccordé au potentiel (BP) de référence et en ce que le dispositif (LA) de ligne est terminé au moins de manière à-peu-près exempt de réflexion par la première résistance (R1), d'une part, et par une résistance (R2) formant appareil utilisateur raccordé à la borne de sortie, d'autre part.

2. Etage amplificateur à large bande suivant la revendication 1, caractérisé en ce que les bornes (B1,B2) de base du premier et du deuxième transistor (T1,T2) sont reliées à une source de signal pour une commande en mode push-pull.

3. Etage amplificateur à large bande suivant la revendication 1, caractérisé en ce que le premier et le deuxième conducteur (L1,L2) sont réunis en une ligne de fils métalliques parallèles.

4. Etage amplificateur à large bande suivant la revendication 1, caractérisé en ce que le premier et le deuxième conducteur (L1,L2) sont réunis en une ligne coaxiale.

5. Etage amplificateur à large bande suivant les revendications 1, 3 ou 4, caractérisé en ce que les conducteurs sont enroulés sur un noyau en ferrite très perméable.